# EUROPÄISCHE PATENTSCHRIFT

(11) **EP 3 126 852 B1**
(45) Veröffentlichungstag und Bekanntmachung des Hinweises auf die Patenterteilung: **27.11.2019**
(21) Anmeldenummer: 15700416.9
(22) Anmeldetag: 13.01.2015
(51) Int. Cl.: G01R 15/14, G01R 1/067

(54) **KONTAKTIERANORDNUNG, INSBESONDERE HF-MESSSPITZE**
CONTACTING ASSEMBLY, IN PARTICULAR AN HF MEASURING TIP
SYSTÈME DE MISE EN CONTACT, EN PARTICULIER POINTE DE MESURE HF

(30) Priorität: 01.04.2014 DE 202014002841 U
(43) Veröffentlichungstag der Anmeldung: 08.02.2017
(73) Patentinhaber: Rosenberger Hochfrequenztechnik GmbH & Co. KG, 83413 Fridolfing (DE)
(72) Erfinder: NEUHAUSER, Roland, 83413 Fridolfing (DE)
(74) Vertreter: Zeitler Volpert Kandlbinder Patent- und Rechtsanwälte Partnerschaft mbB
(86) Internationale Anmeldenummer: PCT/EP2015/000044
(87) Internationale Veröffentlichungsnummer: WO 2015/149893

(56) Entgegenhaltungen:
- WO-A1-03/012461
- WO-A1-03/088410
- DE-T2- 69 822 818
- Wu, K., Deslandes, D. and Cassivi.Y.: "Impedance Transformers and Matching Networks", Encyclopedia of RF and Microwave Engineering , 15. April 2005 (2005-04-15), XP002737432, DOI: 10.1002/0471654507.eme174 Gefunden im Internet: URL:http://onlinelibrary.wiley.com/doi/10. 1002/0471654507.eme174/full [gefunden am 2015-03-23]

## Beschreibung

Die Erfindung betrifft eine Kontaktieranordnung zum Abgreifen und Weiterleiten einer Spannung, insbesondere eine Hochfrequenz-(HF)Messspitze oder HF-Messsonde, mit einem Träger, auf dem eine Leiterstruktur angeordnet ist, wobei die Leiterstruktur an einem kontaktseitigen Ende zumindest ein über einen Rand des Trägers vorstehendes Kontaktelement zum elektrischen Kontaktieren mindestens einer Kontaktstelle eines Prüflings aufweist, und wobei die Leitungsstruktur zumindest einen Impedanzwandler bzw. Impedanz-Transformator aufweist.

Herkömmliche Kontaktieranordnungen in Form von Messspitzen sind u.a. aus der Druckschrift DE 199 45 178 C2 und aus der Druckschrift WO 2006/066676 bekannt. Zum Testen von Prüflingen bspw. in Form von auf Wafern angeordneten elektronischen Schaltungen auf deren Funktionsfähigkeit und deren elektrische Eigenschaften werden üblicherweise Messspitzen verwendet, welche mit vorstehenden Kontaktelementen auf entsprechenden Kontaktstellen der zu prüfenden elektronischen Schaltung mechanisch aufsetzen. Derartige zu testende elektronische Schaltungen erzeugen oder verarbeiten auch Hochfrequenzsignale, so dass sich für die Messspitze eine entsprechend zu beachtende (Wellen-)Impedanz bzw. ein zu beachtender Wellenwiderstand ergibt. Mit anderen Worten muss die Messspitze an ihrem kontaktseitigen Ende eine an die zu prüfende elektronische Schaltung des Prüflings angepasste Impedanz aufweisen, da sich sonst bei Fehlanpassungen, wie allgemein bekannt, Reflexionen ergeben können, welche ein Messergebnis in unerwünschter Weise beeinflussen können oder eine Messung unmöglich machen.

Wenn allerdings an einem dem kontaktseitigen Ende der Leiterstruktur abgewandten verbindungsseitigen Ende der Leiterstruktur zum Weiterleiten der von dem Prüfling abgegriffenen Signale oder Spannungen ein Koaxialkabel oder eine Schaltung mit einer vorgegebenen Impedanz von bspw. 50 Ω oder ein anderes Anschlusselement mit vorgegebener Impedanz angeschlossen wird, kann es erforderlich werden, einen Impedanzwandler in die Leiterstruktur auf dem Träger einzubauen, so dass die Messspitze ohne unerwünschte Reflexionen zur Vermessung eines Prüflings mit davon abweichender Impedanz verwendet werden kann.

Als ein solcher Impedanzwandler kommt ein passives Bauteil wie etwa ein RF-Transformator oder ein anderes surface-mounted device SMD in Frage. Ein solcher Impedanzwandler ist jedoch nur zur Impedanz-Transformation über einen eingeschränkten Frequenzbereich verwendbar. Wenn die ausgehend von dem Prüfling durch die Messspitze geleiteten HF-Signale außerhalb dieses Frequenzbands liegen, werden durch den Impedanzwandler unerwünschte Reflexionen erzeugt.

Die WO 03/012461 A1 offenbart eine Messanordnung für Hochfrequenzmessungen mit mehreren Messsonden zum Kontaktieren von Leiterstrukturen auf Wafern und dergleichen. Die Messsonden umfassen koplanar und freischwebend angeordnete Kontaktspitzen, die mittels mindestens eines Trägers nahe ihrem kontaktseitigen Ende so fixiert werden, so sie eine feste Lage zueinander haben. Die Messanordnung gemäß der WO 03/012461 A1 weist ferner einen als Impedanzwandler ausgebildeten Leiterabschnitt mit sich verjüngendem oder erweiterndem Querschnitt auf.

In Anbetracht der beschriebenen Probleme ist es die Aufgabe der vorliegenden Erfindung, eine Kontaktieranordnung wie etwa eine HF-Messspitze bereitzustellen, die auch über ein breites Frequenzband die zu vermessenden Signale reflexionsfrei weiterleitet und die besonders flexibel einsetzbar ist.

Diese Aufgabe wird erfindungsgemäß durch eine Kontaktieranordnung gemäß Anspruch 1 gelöst. Vorteilhafte Weiterbildungen der Erfindung sind in den abhängigen Ansprüchen beschrieben.

Der Impedanzwandler der erfindungsgemäßen Kontaktieranordnung zeichnet sich dadurch aus, dass er einen elektrischen Leiterabschnitt mit sich allmählich verjüngendem oder erweiterndem Querschnitt aufweist.

Die Erfindung geht auf die Erkenntnis zurück, dass zur Impedanz-Transformation nicht notwendigerweise ein komplexes elektronisches Bauteil wie etwa ein Balun o. dgl. erforderlich ist. Vielmehr genügt es, zur Impedanzwandlung einen Leiterabschnitt mit sich zwischen dem kontaktseitigen Ende und dem verbindungsseitigen Ende der Leiterstruktur allmählich veränderndem Leiterquerschnitt einzusetzen. Die Länge und die Querschnittsänderung dieses Leiterabschnitts sind derart eingerichtet, dass sich der Wellenwiderstand der Leiterstruktur um einen vorgegebenen Wert verändert. Da eine stufige Änderung des Leiterquerschnitts regelmäßig zu Reflexionen führt, erfolgt die Änderung des Leiterquerschnitts erfindungsgemäß bevorzugt allmählich, bevorzugt über eine Wegstrecke von mehr als 5 cm, besonders bevorzugt mehr als 10 cm, insbesondere 20 cm oder mehr.

Die Kontaktieranordnung weist fünf von dem Träger vorstehende Kontaktelemente auf, von denen zumindest zwei Kontaktelemente mit mindestens einem an dem Träger angeordneten Masseleiter verbunden sind, der bevorzugt von dem kontaktseitigen Ende zu dem verbindungsseitigen Ende verläuft.

Wie oben bereits erläutert, können durch einen sich abrupt ändernden Leiterquerschnitt Reflexionen eingeführt werden. Eine abrupte Querschnittsänderung bzw. Leiter-Breitenänderung an dem Übergang zwischen der Leiterbahn und dem schmalen Kontaktelement an dem kontaktseitigen Ende der Leiterstruktur kann dadurch verringert werden, dass fünf voneinander beabstandete Kontaktelemente mit der Leiterbahn elektrisch verbunden sind. Mit anderen Worten wird die Leiterbahn dadurch aufgefächert, dass sie mit mehr als einem von dem Träger vorstehenden Kontaktelement verbunden ist, wobei zwischen den einzelnen signalführenden Kontaktelementen jeweils ein mit dem Masseleiter verbundenes Massekontaktelement angeordnet sein kann. Auf diese Weise kann die Breite der Leiterbahn an dem kontaktseitigen Ende bis hin zu den Spitzen der Kontaktelemente praktisch fortgeführt werden.

Eine abwechselnde Anordnung von Massekontaktelementen und signalführenden Kontaktelementen vergrößert in diesem Fall den Abstand zwischen den einzelnen Kontaktelementen unter Beibehaltung einer niederohmigen Eingangsimpedanz. Wenn bspw. nur ein signalführendes Kontaktelement und ein Massekontaktelement nebeneinander vorhanden sind, ist deren Abstand zur Aufrechterhaltung einer niederohmigen Eingangsimpedanz ggf. auf weniger als 1 µm einzurichten. Ein derart geringer Abstand zwischen zwei Kontaktelementen ist schwierig herstellbar und die entsprechenden Kontaktelemente sind anfällig für Beschädigungen. Wenn andererseits drei oder mehr signalführende Kontaktelemente jeweils zwischen Massekontaktelementen von dem Träger vorstehen, kann ein gegenseitiger Abstand benachbarter Kontaktelemente von mehr als 10 µm ausreichend sein.

Vorzugsweise weist die Leiterstruktur zumindest einen Signalleiter bzw. Spannungsleiter und zumindest einen Masseleiter auf, die jeweils von dem kontaktseitigen Ende zu dem verbindungsseitigen Ende verlaufen, wobei an dem verbindungsseitigen Ende der Leiterstruktur ein Steckverbinder zum Weiterleiten des abgegriffenen Signals angeordnet sein kann. Dabei ist der Leiterabschnitt mit sich veränderndem Querschnitt vorzugsweise in den Signalleiter eingebaut. Der Masseleiter kann ebenso wie der Signalleiter mit einem oder mehreren von dem Träger vorstehenden Kontaktelementen zum elektrischen Kontaktieren mindestens einer Kontaktstelle des Prüflings an dem kontaktseitigen Ende verbunden sein.

Der Träger kann ein Dielektrikum aufweisen, auf dem die Leiterstruktur angeordnet ist. In einer besonders bevorzugten Ausführungsform der Erfindung ist der Träger in Form einer Leiterplatte gebildet, auf der ein Teil der Leiterstruktur als Leiterbahn aufgebracht ist. In diesem Fall kann der Leiterabschnitt mit sich veränderndem Querschnitt als (im Wesentlichen zweidimensionale, also flächig aufgebrachte) Leiterbahn mit sich verringernder oder vergrößernder Breite gebildet sein. Vorzugsweise ist der Signalleiter zumindest abschnittsweise als Leiterbahn gebildet, während der Masseleiter bspw. als Deckschicht aus einem leitenden Material wie etwa Metall auf einer Rückseite der Leiterplatte angeordnet sein kann.

Das Verhältnis zwischen der Leiterbahnbreite an dem einen Ende der Leiterbahn und der Leiterbahnbreite an dem anderen Ende der Leiterbahn ist bevorzugt größer als zwei, besonders bevorzugt größer als drei, insbesondere vier oder mehr. Dieses Verhältnis hängt von der zu erzielenden Impedanz-Transformation ab.

Eine zuverlässige und mit einfachen Mitteln erzielbare Impedanz-Transformation auf eine vorgegebene Eingangs- und/oder Ausgangsimpedanz der Leiterstruktur ist dadurch erreichbar, dass der Impedanzwandler eine Klopfenstein-Struktur bzw. einen "Klopfenstein-Taper" umfasst. Durch einen Klopfenstein-Taper werden zwei unterschiedliche vorgegebene Wellenwiderstands-Niveaus durch einen Leiterabschnitt mit sich verjüngendem Querschnitt auf kurzem Weg unter gleichzeitiger Minimierung von Reflexionen miteinander verbunden. Über eine Klopfenstein-Struktur ist eine Impedanz-Transformation über ein besonders breites HF-Frequenzband ohne störende Reflexionen möglich.

Eine besonders kompakte und kostengünstig herstellbare Kontaktieranordnung kann dadurch bereitgestellt werden, dass der Leiterabschnitt von dem verbindungsseitigen Ende in Richtung auf das kontaktseitige Ende zumindest abschnittsweise kurvig, insbesondere mäanderförmig verläuft. Mit anderen Worten verläuft der sich verjüngende Leiterabschnitt schlangenlinienförmig und weist dabei vorzugsweise mehrere, besonders bevorzugt mehr als fünf, insbesondere sieben oder mehr Krümmungsabschnitte auf, in denen sich die Richtung des Leiterabschnitts um etwa 180° umkehrt. Auf diese Weise kann eine Leiterlänge von bspw. mehr als 30 cm auf einem Trägerbereich einer Länge von bspw. weniger als 10 cm aufgebracht werden. Mit anderen Worten beträgt das Verhältnis zwischen der Länge des Leiterabschnitts und der Längsabmessung des Trägerabschnitts, auf dem der Leiterabschnitt angeordnet ist, drei oder mehr. Die erfindungsgemäße Kontaktieranordnung kann auf besonders einfache Weise dadurch hergestellt werden, dass ein schlangenlinienförmiger Leiterabschnitt in Form einer Leiterbahn auf einer Leiterplatte aufgedruckt oder auf andere Weise aufgebracht wird.

Alternativ kann der sich verjüngende Leiterabschnitt auch linear, also ohne Kurven oder Krümmungen, auf dem Träger gebildet sein. Um dennoch zu einer vergleichsweise kompakten Kontaktieranordnung zu kommen, hat es sich als vorteilhaft erwiesen, dass sich der Leiterabschnitt vorzugsweise in Form einer Leiterbahn über mehr als 50%, vorzugsweise über mehr als 80%, insbesondere über die gesamte Abmessung des Trägers von dem kontaktseitigen Ende bis zu dem verbindungsseitigen Ende erstreckt. Diese Abmessung kann vorteilhafterweise mehr als 6 cm und weniger als 20 cm, insbesondere zwischen 10 und 15 cm betragen. Bei einem linear verlaufenden Leiterabschnitt besteht anders als bei einem kurvig verlaufenden Leiterabschnitt nicht die Gefahr eines Übersprechens zwischen einzelnen Leiterschleifen.

Dabei hat sich herausgestellt, dass ein einen Klopfenstein-Taper aufweisender Impedanzwandler zur Impedanz-Transformation über einen besonders breiten Frequenzbereich von etwa 700 MHz bis etwa 2,7 GHz, bevorzugt von 500 MHz bis 3 GHz, besonders bevorzugt von 400 MHz bis 10 GHz, insbesondere von 300 MHz bis 20 GHz eingerichtet sein kann, wobei der Reflexionsfaktor Γ über den gesamten Frequenzbereich kleiner ist als 0,2, insbesondere kleiner ist als 0,1.

Im Hinblick auf die üblichen Eingangsimpedanzen von HF-Bauteilen und HF-Leitungen, insbesondere Koaxialleitungen, hat es sich als zweckmäßig herausgestellt, dass das Verhältnis zwischen der Eingangsimpedanz und der Ausgangsimpedanz des Impedanzwandlers bzw. der Leiterstruktur auf 5:1, 1:5, 4:1, 1:4, 2:1 oder 1:2 eingerichtet ist. Unter der Ausgangsimpedanz der Leiterstruktur wird die Impedanz der Leiterstruktur an dem verbindungsseitigen Ende zwischen dem den Leiterabschnitt aufweisenden Signalleiter und einem Masseleiter verstanden (verbindungsseitige Impedanz). Unter der Eingangsimpedanz der Leiterstruktur wird die kontaktseitige Impedanz der Leiterstruktur zwischen dem mit dem Leiterabschnitt verbundenen Kontaktelement und einem mit dem Masseleiter verbundenen Kontaktelement verstanden, die an die Wellenimpedanz des zu vermessenden Prüflings angepasst ist.

Dabei beträgt die kontaktseitige Impedanz der Leiterstruktur vorzugsweise etwa 10 Ω oder etwa 12,5 Ω und/oder die verbindungsseitige Impedanz der Leiterstruktur etwa 50 Ω oder umgekehrt. Im diesem Fall kann ein herkömmliches Koaxialkabel an dem verbindungsseitigen Ende der Kontaktieranordnung angeschlossen werden.

Im Hinblick auf eine zuverlässige Kontaktierbarkeit der mindestens einen Kontaktstelle des Prüflings ohne die Gefahr einer Beschädigung von Prüfling oder Kontaktelement hat es sich als zweckmäßig erwiesen, dass das mindestens eine Kontaktelement ein vorzugsweise federnd eingerichteter Kontaktfinger ist. Vorzugsweise sind alle Kontaktelemente einschließlich der mit dem Masseleiter verbundenen Massekontaktelemente als federnd eingerichtete Kontaktfinger gebildet.

Die mehreren kontaktfederartig über einen Trägerrand hinausragenden Kontaktelemente können koplanar angeordnet sein, so dass sie zum Kontaktieren von koplanaren Kontaktstellen des Prüflings eingerichtet sind. Vorzugsweise sind zwei äußere Kontaktelemente Massenelemente, die mit dem Masseleiter verbunden sind, während ein mittleres Kontaktelement mit dem Signalleiter verbunden ist, der den sich verjüngenden Leiterabschnitt aufweist. Der gegenseitige Abstand und die Länge der Kontaktelemente sind jeweils derart eingerichtet, dass sich eine vorgegebene Wellenimpedanz an dem kontaktseitigen Ende ergibt, die an die Wellenimpedanz des Prüflings angepasst ist.

Der mindestens eine Masseleiter kann auf derjenigen Fläche des Trägers angeordnet sein, die der den Leiterabschnitt tragenden Fläche abgewandt ist. Er kann als Metallschicht oder Metalldecke ausgebildet sein, die eine Rückseite des Trägers bedeckt. Alternativ oder zusätzlich kann auch eine Schirmung des Signalleiters der Leiterstruktur vorgesehen sein.

Im Hinblick auf eine Verringerung einer durch die Kontaktieranordnung eingeführten Signalreflexion hat es sich als zweckmäßig erwiesen, dass die von dem Träger vorstehenden Kontaktelemente abwechselnd mit dem Masseleiter und mit dem Leiterabschnitt elektrisch verbunden sind. Eine solche Kontaktelementstruktur kann als GSG-Struktur (Ground-Signal-Ground) bezeichnet werden.

Vorzugsweise sind die beiden äußeren Kontaktelemente Massekontaktelemente, von denen bevorzugt insgesamt vier oder mehr vorhanden sind. Andererseits weist die Kontaktstruktur vorzugsweise drei oder mehr mit der Leiterbahn verbundene signalführende Kontaktelemente auf, die jeweils zwischen zwei Massekontaktelementen vorstehen.

Im Hinblick auf eine impedanzangepasste und stabile Ankopplung der erfindungsgemäßen Kontaktieranordnung an ein Verbindungselement wie etwa ein Kabel oder eine elektronische Schaltung kann die Leiterstruktur an dem dem kontaktseitigen Ende abgewandten verbindungsseitigen Ende ein Anschlusselement wie etwa einen Steckverbinder, insbesondere einen Koaxialsteckverbinder aufweisen, wobei bevorzugt ein Masseleiter der Kontaktstruktur mit einem Außenleiter des Steckverbinders und/oder der Leiterabschnitt der Kontaktstruktur mit einem Innenleiter des Steckverbinders verbunden ist.

Im Hinblick auf die Anordnung der Kontaktelemente an dem Träger sowie im Hinblick auf die Anschlusselemente und die Verbindung zwischen den Kontaktelementen und den Anschlusselementen wird auf die Druckschrift WO 2006/066676 A1 verwiesen.

Die Erfindung wird im Folgenden anhand der Zeichnung näher erläutert. Diese zeigt in
- Fig. 1: eine beispielhafte erste Ausführungsform einer erfindungsgemäßen Kontaktieranordnung in Form einer HF-Messspitze zum Übertragen von HF-Signalen in einer schematischen Draufsicht, und in
- Fig. 2: eine beispielhafte zweite Ausführungsform einer erfindungsgemäßen Kontaktieranordnung in einer schematischen Draufsicht.

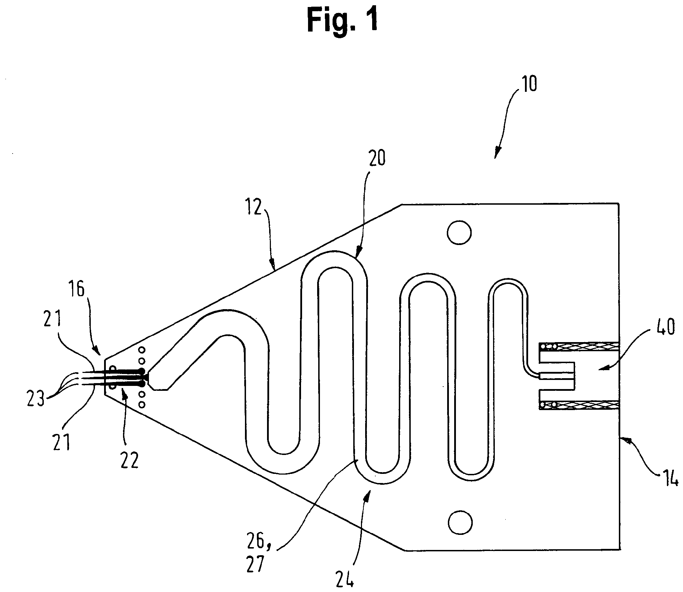

Die aus Figur 1 ersichtliche beispielhafte erste Ausführungsform einer erfindungsgemäßen Kontaktieranordnung 10 zum Übertragen von elektrischen Signalen in Form einer Messspitze für die Vermessung von Prüflingen mit Hochfrequenz-Schaltungen bspw. auf Halbleiterwafern umfasst einen eine Leiterplatte aufweisenden Träger 12, der sich ausgehend von einem verbindungsseitigen Ende 14 in Richtung auf ein kontaktseitiges Ende 16 allmählich verjüngt. Auf dem Träger 12 ist eine Leiterstruktur 20 angeordnet, die von dem verbindungsseitigen Ende 14 zu dem kontaktseitigen Ende 16 verläuft.

Die Leiterstruktur 20 weist zumindest einen Signalleiter und zumindest einen Masseleiter auf, wobei der Masseleiter auf der nicht dargestellten Rückseite des Trägers 12 angeordnet ist, während die den Signalleiter tragende Fläche des Trägers 12 in der dargestellten Figur dem Betrachter zugewandt ist. Alternativ oder zusätzlich kann die Leiterstruktur 20 auch mehrere Signalleiter aufweisen. Alternativ können Signal- und Masseleiter auf derselben Fläche des Trägers 12 angeordnet sein.

Von dem kontaktseitigen Ende 16 des Trägers 12 stehen insgesamt drei federelastische Kontaktelemente 22 in Form von Kontaktfingern 23 über einen Trägerrand hinweg vor, die zum Kontaktieren von entsprechend beabstandeten Kontaktstellen des Prüflings vorgesehen sind. Im dargestellten Beispiel sind der mittlere Kontaktfinger 23 mit dem Signalleiter und die äußeren beiden Kontaktfinger 23 mit dem Masseleiter verbunden. Die äußeren Kontaktfinger 23 sind also Massekontaktelemente 21. Andere Anordnungen der Kontaktelemente oder mehr als drei Kontaktfinger sind gleichermaßen vorstellbar.

An dem verbindungsseitigen Ende 14 des Trägers 14 ist ein Steckverbinder 40 mit einem Innenleiter und einem Außenleiter angeordnet. Ein Koaxialkabel oder ein Gegensteckverbinder kann zur Weiterleitung der über die Kontaktelemente 22 abgegriffenen HF-Signale in den Steckverbinder 40 eingesteckt werden. Der Innenleiter des Steckverbinders 40 ist mit dem Signalleiter und somit mit dem mittleren Kontaktfinger 23 elektrisch verbunden, während der Außenleiter des Steckverbinders 40 mit dem Masseleiter und somit mit den beiden Massekontaktelementen 21 elektrisch verbunden ist.

Die Leiterstruktur 20 weist einen Impedanzwandler 24 auf, wobei der Impedanzwandler 24 einen elektrischen Leiterabschnitt 26 mit sich ausgehend von dem verbindungsseitigen Ende 14 in Richtung auf das kontaktseitige Ende 16 allmählich erweiterndem Querschnitt aufweist. Dieser Leiterabschnitt 26 ist in der dargestellten beispielhaften Ausführungsform in Form einer auf den Träger 12 aufgebrachten Leiterbahn 27 mit sich vergrößernder Breite bereitgestellt. Die Leiterbahn 27 ist Teil des Signalleiters, der zwischen dem mittleren Kontaktfinger 23 und dem Innenleiter des Steckverbinders 40 verläuft. Die geometrische Form und der Verlauf der Leiterbahn 27 sind derart eingerichtet, dass sich eine Klopfenstein-Struktur zur Impedanztransformation zwischen dem verbindungsseitigen Ende 14 und dem kontaktseitigen Ende 16 ergibt. Bei dem dargestellten Beispiel können durch die Kontaktfinger 23 Signale eines Prüflings mit einer Wellenimpedanz von 12,5 Ω abgegriffen werden und über ein an den Steckverbinder 40 anzuschließendes Koaxialkabel mit einer Wellenimpedanz von 50 Ω reflexionsfrei weitergeleitet werden.

Damit stellt die dargestellte Kontaktieranordnung 10 insgesamt einen Impedanzwandler dar, bei dem die Impedanz-Transformation mittels einer Klopfenstein-Struktur erfolgt.

Die Kontaktieranordnung 10 ist zum Abgreifen und zur Weiterleitung von HF-Signalen über ein Frequenzband von etwa 698 MHz bis etwa 2,7 GHz eingerichtet, ohne das Reflexionen auftreten, wobei das Impedanzniveau von 12,5 Ω an dem kontaktseitigen Ende 16 der Leiterstruktur 20 auf 50 Ω an dem verbindungsseitigen Ende der Leiterstruktur 20 angehoben wird. Damit ergibt sich bei dem vorliegenden Beispiel ein Transformationsverhältnis von 1:4. Alternativ kann das Impedanzniveau von 10 Ω an dem kontaktseitigen Ende 16 auf 50 Ω an dem verbindungsseitigen Ende angehoben werden, so dass sich ein Transformationsverhältnis von 1:5 ergibt.

Eine kompaktere Bauweise der Kontaktieranordnung 10 ist dadurch möglich, dass die Leiterbahn 27 zwischen dem Steckverbinder 40 und dem Kontaktfinger 23 schlangenlinienförmig verläuft und mehrere Kurven aufweist. Die Breite der Leiterbahn 27 an dem dem Kontaktelement 22 zugewandten Ende der Leiterbahn 27 ist etwa 4mal so groß wie deren Breite an dem dem Steckverbinder 40 zugewandten Ende. Form, Länge und Verlauf der Leiterbahn 27 können jedoch je nach der zu erreichenden Impedanz-Transformation entsprechend angepasst werden. Der Abstand und die Länge der Kontaktelemente 22 sind derart eingerichtet, dass die kontaktseitige Impedanz an die Impedanz des zu vermessenden Bauteils angepasst ist.

Erfindungsgemäß erfolgt die Impedanz-Transformation allein durch den Verlauf der Leiterbahn 27 des Signalleiters, ohne dass zusätzliche Bauteile wie etwa SMDs erforderlich sind. Damit kann das Frequenzband breitbandiger gestaltet werden und die erfindungsgemäße Kontaktieranordnung somit auch zum Testen von LTE-Bauteilen verwendet werden. Ferner entfällt die Montage/Bestückung eines SMD-Bauteils. Das Transformationsverhältnis des Impedanzwandlers kann individuell variiert werden und kann bspw. 1:5, 5:1, 1:2, 2:1, 1:4, 4:1 etc. betragen.

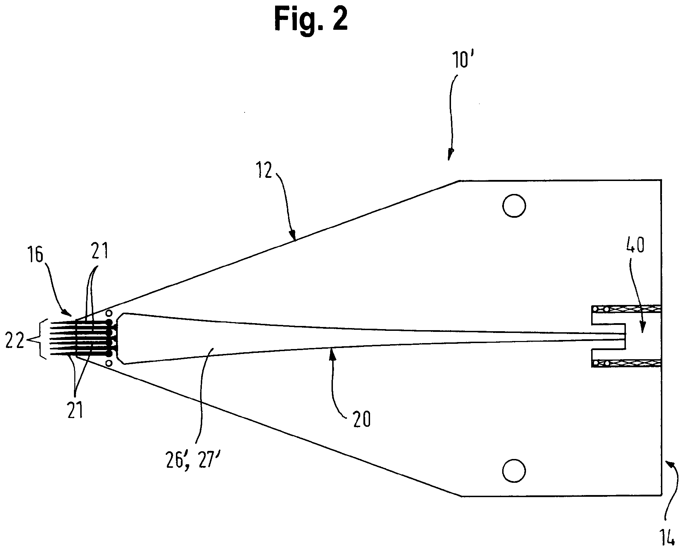

Fig. 2 zeigt eine beispielhafte zweite Ausführungsform einer erfindungsgemäßen Kontaktieranordnung 10'. Bei dieser beispielhaften zweiten Ausführungsform verläuft der Leiterabschnitt 26' in Form einer Leiterbahn 27' nicht schlangenlinienförmig, sondern linear ausgehend von dem steckseitigen Ende 14 bis zu dem kontaktseitigen Ende 16 über den Träger 12. Die Gesamtabmessung des Trägers, die im Wesentlichen der Länge der sich in Richtung auf das verbindungsseitige Ende 14 verjüngenden Leiterbahn 27' entspricht, beträgt dabei etwa 12 cm. Durch den geraden Verlauf des Leiterabschnitts 26' wird ein Übersprechen zwischen einzelnen Leiterschleifen verhindert.

Anders als die beispielhafte erste Ausführungsform weist die Leiterstruktur 20 insgesamt sieben über einen Rand des Trägers 12 vorstehende Kontaktelemente 22 auf, von denen vier Massekontaktelemente 21 jeweils mit einem (gemeinsamen) Masseleiter auf der Rückseite des Trägers 12 verbunden sind und drei signalführende Kontaktelemente mit der Leiterbahn 27' verbunden sind. Dabei wechsein sich die Massekontaktelemente 21 und die signalführenden Kontaktelemente ab. Die beiden äußeren Kontaktelemente 22 sind Massekontaktelemente 21. Alternativ sind auch mehr oder weniger als sieben Kontaktelemente 22 denkbar.

Durch die dargestellte Auffächerung in mehrere mit dem Leiterabschnitt 26' verbundene Kontaktelemente wird ein Reflexion an dem Übergang zwischen den Kontaktelementen 22 und dem (breiten) Ende des Leiterabschnitts 26' minimiert. Ferner kann der Abstand zwischen den einzelnen Kontaktelementen 22 auf diese Weise unter Beibehaltung der gewünschten kontaktseitigen Impedanz größer eingerichtet werden. Vorliegend beträgt der Abstand zwischen zwei benachbarten Kontaktelementen 22 mehr als 10 µm und die kontaktseitige Impedanz etwa 10 Ω. Der gegenseitige Abstand und die Anzahl der Kontaktelemente kann in Abhängigkeit von der gewünschten Impedanz-Transformation entsprechend angepasst werden.

Im übrigen wird auf die Erläuterungen hinsichtlich der in Fig. 1 gezeigten beispielhaften ersten Ausführungsform verwiesen, die für die beispielhafte zweite Ausführungsform entsprechend gelten.

### Bezugszeichenliste

- 10, 10': Kontaktieranordnung
- 12: Träger/Leiterplatte
- 14: verbindungsseitiges Ende
- 16: kontaktseitiges Ende
- 20: Leitungsstruktur
- 21: Massekontaktelemente
- 22: Kontaktelemente
- 23: federne Kontaktfinger
- 24: Impedanzwandler
- 26,26': Leiterabschnitt
- 27,27': Leiterbahn
- 40: Steckverbinder

## Patentansprüche

1. Kontaktieranordnung (10; 10'), insbesondere HF-Messspitze, mit einem Träger (12), an dem eine Leiterstruktur (20) angeordnet ist, wobei die Leiterstruktur (20) an einem kontaktseitigen Ende (16) mindestens fünf von dem Träger vorstehende Kontaktelemente (22) zum elektrischen Kontaktieren mindestens einer Kontaktstelle eines Prüflings aufweist, und wobei die Leiterstruktur (20) einen impedanzwandier (24) aufweist, wobei der impedanzwandler (24) einen Leiterabschnitt (26; 26') mit sich allmählich verjüngendem oder erweiterndem Querschnitt aufweist, wobei von den vorstehenden Kontaktelementen (22) zwei als Massekontaktelemente (21) ausgebildete Kontaktelemente (22) mit einem an dem Träger (12) angeordneten Masseleiter und die drei verbleibenden Kontaktelemente mit dem Leiterabschnitt (26; 26') verbunden sind, wobei der Masseleiter ausgehend von dem kontaktseitigen Ende (16) zu einem verbindungsseitigen Ende (14) verläuft, und wobei die von dem Träger (12) vorstehenden Kontaktelemente (22) abwechselnd mit dem Masseleiter und mit dem Leiterabschnitt (26; 26') elektrisch verbunden sind.

2. Kontaktieranordnung nach Anspruch 1, **dadurch gekennzeichnet, dass** der Leiterabschnitt (26; 26') eine auf einem Dielektrikum, insbesondere auf einer Leiterplatte aufgebrachte Leiterbahn (27; 27') mit sich allmählich verringernder oder vergrößernder Breite ist.

3. Kontaktieranordnung nach Anspruch 1 oder 2, **dadurch gekennzeichnet, dass** der Impedanzwandler (24) eine Klopfenstein-Struktur umfasst.

4. Kontaktieranordnung (10) nach mindestens einem der vorhergehenden Ansprüche, **dadurch gekennzeichnet, dass** der Leiterabschnitt (26) zumindest abschnittsweise kurvig, insbesondere mäanderförmig oder schlangenlinienförmig verläuft.

5. Kontaktieranordnung (10') nach mindestens einem der Ansprüche 1 bis 3, **dadurch gekennzeichnet, dass** der Leiterabschnitt (26') im Wesentlichen linear verläuft und sich bevorzugt über mehr als 50%, insbesondere über 80% oder mehr der Abmessung des Trägers (12) erstreckt.

6. Kontaktieranordnung nach mindestens einem der vorhergehenden Ansprüche, **dadurch gekennzeichnet, dass** der Impedanzwandler (24) zur Impedanztransformation über ein Frequenzband von etwa 700 MHz bis etwa 2,7 GHz, bevorzugt von 500 MHz bis 3 GHz, besonders bevorzugt von 400 MHz bis 10 GHz, insbesondere von 300 MHz bis 20 GHz eingerichtet ist.

7. Kontaktieranordnung nach mindestens einem der vorhergehenden Ansprüche, **gekennzeichnet durch** ein Verhältnis zwischen der Eingangsimpedanz und der Ausgangsimpedanz des Impedanzwandlers (24) und/oder der Leiterstruktur (20) von 5:1, 1:5, 4:1, 1:4, 2:1 oder 1:2.

8. Kontaktieranordnung nach Anspruch 6, **dadurch gekennzeichnet, dass** die Eingangsimpedanz an dem kontaktseitigen Ende der Leiterstruktur (20) etwa 10 Ω oder etwa12,5 Ω beträgt und/oder die Ausgangsimpedanz der Leiterstruktur (20) an einem dem kontaktseitigen Ende abgewandten verbindungsseitigen Ende (14) etwa 50 Ω beträgt oder umgekehrt.

9. Kontaktieranordnung nach mindestens einem der vorhergehenden Ansprüche, **dadurch gekennzeichnet, dass** das mindestens eine Kontaktelement (22) ein vorzugsweise federnd eingerichteter Kontaktfinger (23) ist.

10. Kontaktieranordnung nach mindestens einem der vorhergehenden Ansprüche, **dadurch gekennzeichnet, dass** der mindestens eine Masseleiter an einer dem Leiterabschnitt (26; 26') entgegengesetzten Fläche des Trägers (12) gebildet ist.

11. Kontaktieranordnung nach mindestens einem der vorhergehenden Ansprüche, **dadurch gekennzeichnet, dass** die Leiterstruktur (20) an dem dem kontaktseitigen Ende (16) abgewandten verbindungsseitigen Ende (14) ein Anschlusselement wie etwa einen Steckverbinder (40), insbesondere einen Koaxialsteckverbinder aufweist, wobei bevorzugt ein Masseleiter der Leiterstruktur (20) mit einem Außenleiter des Steckverbinders (40) und der Leiterabschnitt (26) der Leiterstruktur (20) mit einem Innenleiter des Steckverbinders (40) elektrisch verbunden ist.

## Claims

1. Contacting assembly (10; 10'), in particular an HF measuring tip, comprising a carrier (12) on which a conductor structure (20) is arranged, wherein the conductor structure (20) has, at a contact end (16), at least five contact elements (22) projecting from the carrier for making electrical contact with at least one contact point of a device under test, and wherein the conductor structure (20) has an impedance converter (24), wherein the impedance converter (24) has a conductor segment (26; 26') with gradually narrowing or widening cross section, wherein, of the projecting contact elements (22), two contact elements (22) in the form of ground contact elements (21) are connected with a ground conductor arranged on the carrier (12) and the three remaining contact elements are connected with the conductor segment (26; 26'), wherein the ground conductor runs, starting out from the contact end (16), to a connection end (14), and wherein the contact elements (22) projecting from the carrier (12) are alternatingly connected, electrically, with the ground conductor and with the conductor segment (26; 26').

2. Contacting assembly according to claim 1, **characterised in that** the conductor segment (26; 26') is a conductor trace (27; 27') with gradually reducing or increasing width applied to a dielectric, in particular to a circuit board.

3. Contacting assembly according to claim 1 or 2, **characterised in that** the impedance converter (24) comprises a Klopfenstein structure.

4. Contacting assembly (10) according to at least one of the preceding claims, **characterised in that**, at least in sections, the conductor segment (26) runs in curves, in particular in the form of a meander or in a serpentine path.

5. Contacting assembly (10') according to at least one of the claims 1 to 3, **characterised in that** the conductor segment (26') runs in a substantially linear path and preferably extends over more than 50%, in particular over 80% or more of the dimension of the carrier (12).

6. Contacting assembly according to at least one of the preceding claims, **characterised in that** the impedance converter (24) is configured for impedance transformation over a frequency band from around 700 MHz to around 2.7 GHz, preferably from 500 MHz to 3 GHz, particularly preferably from 400 MHz to 10 GHz, in particular from 300 MHz to 20 GHz.

7. Contacting assembly according to at least one of the preceding claims, **characterised by** a ratio between the input impedance and the output impedance of the impedance converter (24) and/or the conductor structure (20) of 5:1, 1:5, 4:1, 1:4, 2:1 or 1:2.

8. Contacting assembly according to claim 6, **characterised in that** the input impedance at the contact end of the conductor structure (20) is around 10 Ω or around 12.5 Ω and/or the output impedance of the conductor structure (20) at a connection end (14) opposite the contact end is around 50 Ω or vice versa.

9. Contacting assembly according to at least one of the preceding claims, **characterised in that** the at least one contact element (22) is a preferably spring-biased contact finger (23).

10. Contacting assembly according to at least one of the preceding claims , **characterised in that** the at least one ground conductor is formed on a surface of the carrier (12) opposite to the conductor segment (26; 26').

11. Contacting assembly according to at least one of the preceding claims, **characterised in that** the conductor structure (20) has a connecting element such as a plug conductor (40), in particular a coaxial plug connector, on a connection end (14) opposite the contact end (16), wherein preferably a ground conductor of the conductor structure (20) is connected with an outer conductor of the plug conductor (40) and the conductor segment (26) of the conductor structure (20) is connected electrically with an inner conductor of the plug conductor (40).

## Revendications

1. Ensemble de mise en contact (10 ; 10'), en particulier pointe de mesure HF, comportant un support (12) sur lequel est agencée une structure conductrice (20),
dans lequel
la structure conductrice (20) présente, à une extrémité (16) côté contact, au moins cinq éléments de contact (22) saillant du support et destinés à la mise en contact électrique d'au moins un emplacement de contact d'une éprouvette,
la structure conductrice (20) présente un transformateur d'impédance (24), le transformateur d'impédance (24) présente une portion conductrice (26 ; 26') ayant une section transversale qui se rétrécit ou s'élargit progressivement,
parmi lesdits éléments de contact (22), deux éléments de contact (22) réalisés sous forme d'éléments de contact de masse (21) sont connectés à un conducteur de masse disposé sur le support (12), et les trois éléments de contact restants sont connectés à la portion conductrice (26 ; 26'),
le conducteur de masse s'étend en partant de l'extrémité (16) côté contact jusqu'à une extrémité (14) côté connexion, et
les éléments de contact (22) saillant du support (12) sont connectés électriquement en alternance au conducteur de masse et à la portion conductrice (26 ; 26').

2. Ensemble de mise en contact selon la revendication 1,
**caractérisé en ce que**
la portion conductrice (26 ; 26') est une piste conductrice (27 ; 27') ayant une largeur qui diminue ou augmente progressivement et étant déposée sur un diélectrique, en particulier sur une carte à circuits.

3. Ensemble de mise en contact selon la revendication 1 ou 2,
**caractérisé en ce que**
le transformateur d'impédance (24) comprend une structure dite de Klopfenstein.

4. Ensemble de mise en contact (10) selon l'une au moins des revendications précédentes,
**caractérisé en ce que**
la portion conductrice (26) s'étend au moins localement sous forme incurvée, en particulier en forme de méandres ou en forme de serpentin.

5. Ensemble de mise en contact (10') selon l'une au moins des revendications 1 à 3,
**caractérisé en ce que**
la portion conductrice (26') s'étend au moins sensiblement linéairement et s'étend de préférence sur plus de 50 %, en particulier sur 80 % ou plus de l'extension du support (12).

6. Ensemble de mise en contact (10) selon l'une au moins des revendications précédentes,
**caractérisé en ce que**
le transformateur d'impédance (24) est conçu pour une transformation d'impédance sur une bande de fréquence d'environ 700 MHz à environ 2,7 GHz, de préférence de 500 MHz à 3 GHz, de manière particulièrement préférée de 400 MHz à 10 GHz, en particulier de 300 MHz à 20 GHz.

7. Ensemble de mise en contact (10) selon l'une au moins des revendications précédentes,
**caractérisé par**
un rapport entre l'impédance d'entrée et l'impédance de sortie du transformateur d'impédance (24) et/ou de la structure conductrice (20) de 5:1, 1:5, 4:1, 1:4, 2:1 ou 1:2.

8. Ensemble de mise en contact selon la revendication 6,
**caractérisé en ce que**
l'impédance d'entrée à l'extrémité côté contact de la structure conductrice (20) est d'environ 10 Ω ou d'environ 12,5 Ω, et/ou l'impédance de sortie de la structure conductrice (20) à une extrémité (14) côté connexion détournée de l'extrémité côté contact est d'environ 50 Ω, ou inversement.

9. Ensemble de mise en contact (10) selon l'une au moins des revendications précédentes,
**caractérisé en ce que**
au moins un élément de contact (22) est un doigt de contact (23) de préférence à effet ressort.

10. Ensemble de mise en contact (10) selon l'une au moins des revendications précédentes,
**caractérisé en ce que**
ledit au moins un conducteur de masse est réalisé sur une surface du support (12) opposée à la portion conductrice (26 ; 26').

11. Ensemble de mise en contact (10) selon l'une au moins des revendications précédentes,
**caractérisé en ce que**
à l'extrémité (14) côté connexion détournée de l'extrémité (16) côté contact, la structure conductrice (20) présente un élément de raccordement, tel qu'un connecteur d'enfichage (40), en particulier un connecteur d'enfichage coaxial, et
de préférence un conducteur de masse de la structure conductrice (20) est connecté électriquement à un conducteur extérieur du connecteur d'enfichage (40), et la portion conductrice (26) de la structure conductrice (20) est connectée électriquement à un conducteur intérieur du connecteur d'enfichage (40).
